# EUROPEAN PATENT APPLICATION

(11) **EP 3 434 968 A1**
(43) Date of publication of application: **30.01.2019**
(21) Application number: 17382504.3
(22) Date of filing: 28.07.2017
(51) Int. Cl.: F21S 41/148, F21S 41/19, F21S 41/36, F21S 45/00, B60Q 1/26, F21S 43/19, H05K 1/11

(54) **AUTOMOTIVE ELECTRONIC ASSEMBLY AND METHOD**

(71) Applicant: Valeo Iluminacion, 23600 Martos (ES)
(72) Inventor: GUZMAN, Alfonso-Manuel, 23600 Martos (ES); TEBA, Daniel, 23600 Martos (ES); MEDINA, Manuel-Jesus, 23600 Martos (ES); SANCHEZ, Juan-Alberto, 23600 Martos (ES); MARTINEZ, Juan-Carlos, 23600 Martos (ES); MARTINEZ, Francisco, 23600 Martos (ES)

(57) **Abstract**

This invention is related to an automotive electronic assembly (1) which comprises a plastics substrate (2) with a first face (21) and a second face (22) opposite the first face (21). A first conductive track (31) deposited on the first face (21) and a second conductive track (32) deposited on the second face (22). Further, a conductive connector (4) is arranged in electric connection with the first conductive track (31) and with the second conductive track (32). The conductive connector is arranged piercing the plastics substrate (2) from the first face (21) to the second face (22).

## Description

### TECHNICAL FIELD

The present invention belongs to the field of electronic assemblies comprising conductive tracks directly deposited on a plastics substrate.

### STATE OF THE ART

Automotive lighting devices require the arrangement of electric circuits to feed light sources. As every arrangement related to the automotive industry, space and cost need to be minimized, which is not normally the case when conventional printed circuit boards (PCB) are used in automotive lighting devices.

Wire bonding and ribbon bonding are usually employed to electrically connect two points which are not arranged in the same substrate. An alternative to simple methods is the use of expensive flexible printed circuit boards, which provide a greater design flexibility, but at the expense of a higher cost.

### DESCRIPTION OF THE INVENTION

The invention provides a solution for this problem by means of an automotive electronic assembly according to claim 1 and a method for manufacturing an automotive electronic assembly according to claim 12. Preferred embodiments of the invention are defined in dependent claims.

In an inventive aspect, the invention provides an automotive electronic assembly comprising
a plastics substrate with a first face and a second face opposite the first face;
a first conductive track deposited on the first face;
a second conductive track deposited on the second face; and
a conductive connector in electric connection with the first conductive track and with the second conductive track,
wherein the conductive connector is arranged piercing the plastics substrate from the first face to the second face.

This electronic assembly does not need any fragile or expensive connections, such as ribbon or wire bonding or flexible printed circuit boards, to create electric connections between the electronic elements comprised in connection with the first and second conductive tracks.

In some particular embodiments, the conductive connector is a rivet.

A rivet provides a simple and secure connection between both faces, easy to install and reliable to operate.

In some particular embodiments, the first and second conductive tracks are directly deposited on the first face and second face respectively.

Direct deposition of a conductive track on a plastics substrate should be construed as forming the final shape of the conductive track on the plastics substrate without the need of removing metal or for any other intermediate element, such as a mask, an electrolyte or any other chemical bath or a photosensitive film. The conductive track is just directly placed on the plastics substrate. Hence, this is a much simpler process to arrange the conductive tracks on the plastics substrate.

Directly depositing a conductive track on a plastics substrate supposes substantial cost savings, due to the fact that a dedicated printed circuit board need not be provided. Therefore, other integral parts of the device to be controlled with the electronic assembly can be taken advantage of to play the role of substrate for the conductive track, leading to a more compact electronic assembly.

Furthermore, the process of direct deposition of the conductive track usually implies shorter manufacturing times and conductive material savings -in contrast to most PCB manufacturing methods, there is no need for removing regions of conductive material or for using an additional product, such as an electrolyte, to define the conductive track.

In some particular embodiment, the conductive track is deposited by plasma deposition.

This step may be carried out, for instance, using the device described in document US 2015/174686 A1, and concretely in its claim 1. These conductive tracks suit perfectly for this automotive electronic assembly, as they are deposited directly over the plastics substrate, without the need for any flexible printed circuit board to provide electric connection between two different faces of the heat sink.

In some particular embodiments, the conductive track is deposited as a bare wire.

Bare wires allow the use of medium and high-power electronics, and are very easy to deposit if an automated machine is used.

In some particular embodiments, the plastics substrate is a three-dimensional plastics substrate.

A three-dimensional plastics substrate should be construed as a plastics substrate whose surface on which the conductive track extends is not completely contained in a plane. Direct deposition is particularly appropriate for such three-dimensional surfaces, in comparison to other known techniques which normally require planar surfaces for printing a circuit board.

In some particular embodiments, the automotive electronic assembly comprises more than one first conductive track, more than one second conductive track and more than one conductive connector.

More complex circuits may be designed, since the conductive connectors may connect the two faces of the plastics substrate in any point, not necessarily near an edge.

In some particular embodiments, the automotive electronic assembly comprises a plurality of light sources, at least an upper semiconductor light source being located on the first face and at least a lower semiconductor light source being located on the second face.

This arrangement may be used in the provision of two different functionalities in an automotive lighting device, such as low beam, high beam, cornering light, etc.

In some particular embodiments, the automotive electronic assembly further comprises
an upper reflector arranged to reflect the light emitted by the at least one upper light source;
a lower reflector arranged to reflect the light emitted by the at least one lower light source; and
a diaphragm element configured to block at least part of the light reflected by the upper reflector in order to form a low-beam light pattern.

Due to the use of connected circuits in both faces of the plastics substrate, more complex functionalities may be achieved in a smaller device.

In a further inventive aspect, the invention refers to a lighting device comprising
an automotive electronic assembly according to the previous inventive aspect;
an optical element suitable for receiving light emitted by the light source and for shaping the light into a light pattern projected outside the lighting device; and
a housing accommodating the automotive electronic assembly and the optical element.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements.

Lighting devices for automotive vehicles can benefit from the use of electronic assemblies comprising conductive tracks directly deposited on a plastics substrate. In the first place, a wide range of the lighting device's parts can be used either as plastics substrate or as base for the plastics substrate (in which case the plastics substrate may for instance coat the base), taking into account that even three-dimensional plastics substrates are suitable for direct deposition of conductive tracks. Therefore, a dedicated printed board circuit is not required, which leads to reducing the cost and the weight of the lighting device. As was stated above, cost savings are even more significant due to the fact that direct deposition does not normally want removing conductive material to shape the conductive tracks.

In a further inventive aspect, the invention provides a method for manufacturing an automotive electronic assembly according to the first inventive aspect, the method comprising the steps of
providing a plastics substrate with a first face and a second face opposite the first face;
depositing a first conductive track on the first face, a second conductive track on the second face and arranging a conductive connector piercing the plastics substrate from the first face to the second face,
wherein the conductive connector is in electric contact with the first conductive track and with the second conductive track.

This is an easy way of obtaining such an automotive electronic assembly, without using any fragile or expensive connections, such as ribbon or wire bonding or flexible printed circuit boards, to create electric connections between the electronic elements comprised in connection with the first and second conductive tracks.

In some particular embodiments, the first and second conductive tracks are deposited prior to the arrangement of the conductive connector.

In these embodiments, any slight misalignment in the position of the conductive tracks may be detected and corrected before piercing the plastics substrate with the conductive connector.

In some particular embodiments, the arrangement of the conductive connector piercing the plastics substrate from the first face to the second face is performed prior to the deposition of the first conductive track and the second conductive track in contact with the conductive connector.

The conductive tracks are not affected by the piercing operation which, in the particular cases of some types of conductive tracks, may affect to the conductive properties of said conductive tracks.

In some particular embodiments, the step of depositing a conductive track directly on the plastics substrate is carried out by plasma deposition.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figures 1a and 1b show different perspective views of an electronic assembly according to the invention.
Figures 2a and 2b show a perspective view of a different embodiment of an electronic assembly according to the invention.
Figure 3 shows an automotive vehicle with a lighting device comprising an electronic assembly according to the invention.

### DETAILED DESCRIPTION OF AN EMBODIMENT OF THE INVENTION

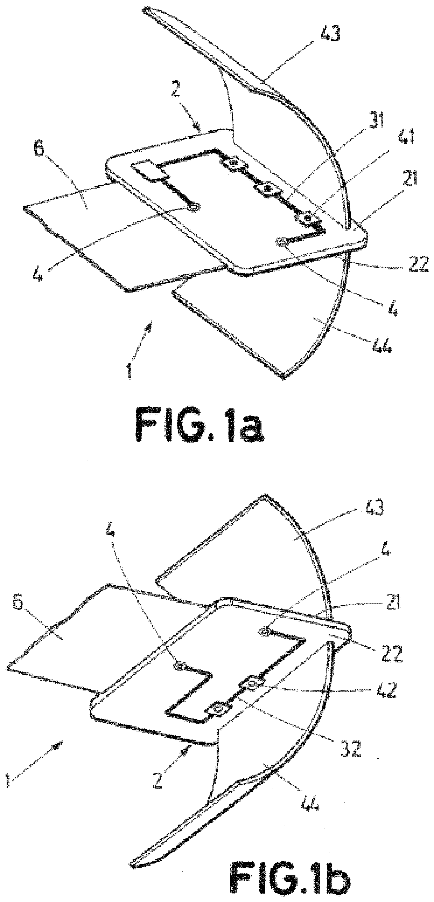

Figures 1 a and 1 b: different perspective views of the electronic assembly conductive tracks being deposited by plasma deposition
Figures 1 a and 1b show different perspective views of an electronic assembly according to the invention. This automotive electronic assembly 1 comprises
a three-dimensional plastics substrate 2 with a first face 21 and a second face 22 opposite the first face 21;
first conductive tracks 31 deposited on the first face 21;
second conductive tracks 32 deposited on the second face 22; and
conductive connectors 4, each one being in electric connection with at least one of the first conductive tracks 31 and with at least one of the second conductive tracks 32, wherein the conductive connector 4 is arranged piercing the three-dimensional plastics substrate 2 from the first face 21 to the second face 22.

In the embodiment seen in this figure, the conductive connector 4 is a rivet. However, any other suitable conductive connector may be used in other embodiments of this invention.

The first 31 and second 32 conductive tracks are directly deposited by plasma deposition.

This electronic assembly 1 further comprises a plurality of light sources 41, 42 installed in the three-dimensional plastics substrate 2. A plurality of upper semiconductor light sources 41 are arranged on the first face 21 and a plurality of lower semiconductor light sources 42 are arranged on the second face 22.

This automotive electronic assembly 1 further comprises an upper reflector 43 arranged to reflect the light emitted by the upper light sources 41, a lower reflector 44 arranged to reflect the light emitted by the lower light sources 42 and a diaphragm element 6 configured to block at least part of the light reflected by the upper reflector 44 in order to form a low-beam light pattern.

This electronic assembly 1 may be used as part of an automotive headlamp, and provide two different lighting functions.

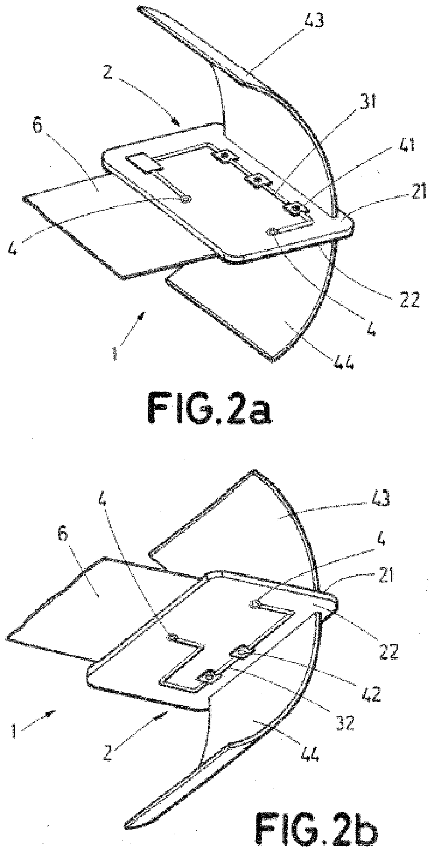

Figures 2a and 2b show a perspective view of a different embodiment of an electronic assembly according to the invention.

In the embodiment shown in this figure, the conductive tracks 31, 32 are deposited as bare wires. Bare wires are deposited so that some of them contact the conductive connectors 4, in order to achieve a circuit pattern which is suitable for the purpose of providing lighting functionalities to the automotive headlamp where the electronic assembly is installed.

In the manufacturing of this electronic assembly, the first and second conductive tracks 31, 32 are deposited on the three-dimensional plastics substrate 2, either by plasma deposition or by any other suitable means. Once said conductive tracks 31, 32 have been deposited, the conductive connector 4 is arranged piercing the three-dimensional plastics substrate 2 from the first face 21 to the second face 22, in electric contact with some of said conductive tracks 31, 32. In alternative embodiments, the conductive connector 4 is arranged first, and then the conductive tracks 31, 32 are deposited, some of them being in electric contact with the corresponding conductive connector 4.

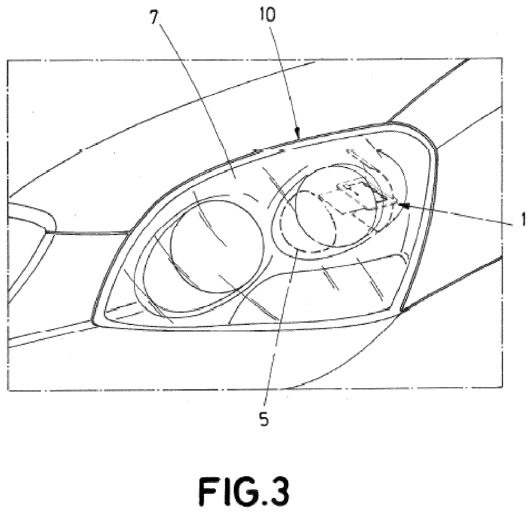

Figure 3 shows an automotive vehicle with a lighting device comprising an electronic assembly according to the invention.

This lighting device 10 comprises
an automotive electronic assembly 1 according to the invention, as shown in any of the previous figures;
an optical element 5 suitable for receiving light emitted by the light sources and for shaping the light into a light pattern projected outside the lighting device 10; and
a housing 7 accommodating the automotive electronic assembly 1 and the optical element 5.

## Claims

1. An automotive electronic assembly (1) comprising
a plastics substrate (2) with a first face (21) and a second face (22) opposite the first face (21);
a first conductive track (31) deposited on the first face (21);
a second conductive track (32) deposited on the second face (22); and
a conductive connector (4) in electric connection with the first conductive track (31) and with the second conductive track (32),
wherein the conductive connector is arranged piercing the plastics substrate (2) from the first face (21) to the second face (22).

2. Automotive electronic assembly (1) according to claim 1, wherein the conductive connector is a rivet.

3. Automotive electronic assembly (1) according to any of the preceding claims, wherein the first and second conductive tracks are directly deposited on the first face and second face respectively.

4. Automotive electronic assembly (1) according to claim 3, the conductive tracks (31, 32) being deposited by plasma deposition.

5. Automotive electronic assembly (1) according to claim 3, the conductive tracks (31, 32) being deposited as bare wires.

6. Automotive electronic assembly (1) according to any of the preceding claims, wherein the plastics substrate is a three-dimensional plastics substrate.

7. Automotive electronic assembly (1) according to any of the preceding claims, comprising more than one first conductive track, more than one second conductive track and more than one conductive connector.

8. Automotive electronic assembly (1) according to any of the preceding claims, comprising a plurality of light sources (41, 42), at least an upper semiconductor light source (41) being located on the first face (21) and at least a lower semiconductor light source (42) being located on the second face (22).

9. Automotive electronic assembly (1) according to claim 8, further comprising
an upper reflector (43) arranged to reflect the light emitted by the at least one upper light source (41);
a lower reflector (44) arranged to reflect the light emitted by the at least one lower light source (42); and
a diaphragm element (6) configured to block at least part of the light reflected by the upper reflector (44) in order to form a low-beam light pattern.

10. Lighting device (10) comprising
an automotive electronic assembly (1) according to claim 9;
an optical element (5) suitable for receiving light emitted by the light sources (41, 42) and for shaping the light into a light pattern projected outside the lighting device (10); and
a housing (7) accommodating the automotive electronic assembly and the optical element (5).

11. A method for manufacturing an automotive electronic assembly (1) according to any of claims 1 to 9, the method comprising the steps of
providing a plastics substrate (2) with a first face (21) and a second face (22) opposite the first face (21);
depositing a first conductive track (31) on the first face (21), a second conductive track (32) on the second face (22) and arranging a conductive connector (4) piercing the plastics substrate (2) from the first face (21) to the second face (22),
wherein the conductive connector (4) is in electric contact with the first conductive track (31) and with the second conductive track (32).

12. Method according to claim 11, wherein the first (31) and second (32) conductive tracks are deposited prior to the arrangement of the conductive connector (4).

13. Method according to claim 11, wherein the arrangement of the conductive connector (4) piercing the plastics substrate (2) from the first face (21) to the second face (22) is performed prior to the deposition of the first conductive track (31) and the second conductive track (32) in contact with the conductive connector (4).

14. Method according to any of claims 11 to 13, wherein the step of depositing a conductive track (31, 32) directly on the plastics substrate (2) is carried out by plasma deposition.
